# EUROPEAN PATENT APPLICATION

(11) **EP 4 496 011 A1**
(43) Date of publication of application: **22.01.2025**
(21) Application number: 23771088.4
(22) Date of filing: 15.03.2023
(51) Int. Cl.: H01L 33/06, H01L 33/02, H01L 33/26, H01L 33/48, H01L 33/62

(54) **LIGHT-EMITTING DIODE AND LIGHT-EMITTING DEVICE HAVING SAME**

(30) Priority: 17.03.2022 US 202263320892 P; 10.03.2023 US 202318120168
(71) Applicant: Seoul Viosys Co., Ltd., Ansan-si, Gyeonggi-do 15429 (KR)
(72) Inventor: MIN, Dae Hong, Ansan-Si Gyeonggi-do 15429 (KR); BAEK, Yong Hyun, Ansan-Si Gyeonggi-do 15429 (KR); KANG, Ji Hun, Ansan-Si Gyeonggi-do 15429 (KR)
(74) Representative: Stolmár & Partner Patentanwälte PartG mbB
(86) International application number: PCT/KR2023/003469
(87) International publication number: WO 2023/177209

(57) **Abstract**

A light-emitting diode and a light-emitting device having same are provided. The light-emitting diode according to an embodiment comprises: a first conductive type semiconductor layer; a second conductive type semiconductor layer; a lower active layer disposed between the first conductive type semiconductor layer and the second conductive type semiconductor layer; and an upper active layer disposed between the lower active layer and the second conductive type semiconductor layer, wherein the lower active layer emits light of a shorter wavelength than the upper active layer, the upper active layer includes a plurality of well layers and a plurality of barrier layers, at least one of the plurality of barrier layers includes a first barrier layer and a second barrier layer having a lower doping concentration of n-type impurities than the first barrier layer, and the first barrier layer is closer to the first conductive type semiconductor layer than the second barrier layer.

## Description

### [Technical Field]

Exemplary embodiments relate to a light emitting diode, and more particularly, to a light emitting diode emitting light having multi-bands at a single chip level.

### [Background Art]

A nitride semiconductor is used as a light source of a display apparatus, traffic light, lighting, or an optical communication device, and is mainly used in a light emitting diode or a laser diode that emits blue or green light. In addition, the nitride semiconductor may be used in a heterojunction bipolar transistor (HBT), a high electron mobility transistor (HEMT), and the like.

In general, a light emitting diode using the nitride semiconductor has a heterojunction structure having a quantum well structure between an N contact layer and a P contact layer. The light emitting diode emits light according to a composition of a well layer in the quantum well structure. In order to increase an internal quantum efficiency and reduce the loss due to light absorption, the light emitting diode is designed to emit light of a spectrum having a single peak, that is, monochromatic light.

Mixed color light, such as white light, emitted from lighting or the like cannot be implemented as single-peak monochromatic light. Accordingly, a technique of implementing white light by using a plurality of light emitting diodes together emitting different monochromatic light from one another or by using a phosphor converting a wavelength of light emitted from the light emitting diode is generally used.

The use of phosphors comes with cost of phosphor or a decrease in efficiency known as a Stoke's shift. In addition, a process of coating phosphor on the light emitting diode and yellowing of a carrier carrying phosphor should also be considered.

Using a mixture of a plurality of light emitting diodes also complicates the process, and it is inconvenient to prepare light emitting diodes made of different materials.

If light having a spectrum of multi-bands can be implemented using a single-chip light emitting diode, there is no need to manufacture the light emitting diodes using different materials, and an amount of phosphor used may be reduced or the use of phosphor may be avoided.

### [DISCLOSURE]

### [Technical Problem]

Exemplary embodiments provide a light emitting diode that emits light having a spectrum of multi-bands at a single chip level, and a light emitting device having the same.

Exemplary embodiments provide a novel technique to adjust relative intensities between bands of a spectrum of multi-bands.

Exemplary embodiments provide a novel technology capable of increasing an intensity of light of a relatively shorter-wavelength band even under a low current density condition.

### [Technical Solution]

A light emitting diode according to an exemplary embodiment of the present disclosure includes a first conductivity type semiconductor layer; a second conductivity type semiconductor layer; a lower active layer disposed between the first conductivity type semiconductor layer and the second conductivity type semiconductor layer; and an upper active layer disposed between the lower active layer and the second conductivity type semiconductor layer, in which the lower active layer emits light having a wavelength shorter than that of the upper active layer, the upper active layer includes a plurality of well layers and a plurality of barrier layers, at least one of the plurality of barrier layers includes a first barrier layer and a second barrier layer having an n-type impurity doping concentration lower than that of the first barrier layer, and the first barrier layer is closer to the first conductivity type semiconductor layer than the second barrier layer.

The lower active layer may emit light having a first peak intensity at less than 500nm, and the upper active layer may emit light having a second peak intensity at 500nm or more.

The second barrier layer may be doped with a lower doping concentration than that of the first barrier layer or may be formed without intentional doping.

All of the plurality of barrier layers may include the first barrier layer and the second barrier layer.

More than half of the plurality of barrier layers, except for some barrier layers, may include the first barrier layer and the second barrier layer, and the barrier layers including the first barrier layer and the second barrier layer may be disposed close to the second conductivity type semiconductor layer.

Half of the plurality of barrier layers may include the first barrier layer and the second barrier layer, and the barrier layers including the first barrier layer and the second barrier layer may be disposed close to the second conductivity type semiconductor layer.

Less than half of the plurality of barrier layers may include the first barrier layer and the second barrier layer, and the barrier layers including the first barrier layer and the second barrier layer may be disposed close to the second conductivity type semiconductor layer.

At least two barrier layers among the plurality of barrier layers may include the first barrier layer and the second barrier layer, and the second barrier layers of the at least two barrier layers may have different doping concentrations from each other.

The at least two barrier layers may be arranged in an order of high or low doping concentration.

The barrier layers including the first barrier layer and the second barrier layer may be disposed close to the second conductivity type semiconductor layer.

Each of the plurality of well layers may include In, an In content profile in the upper active layer may have peak points and valley points, a doping profile of the n-type impurity in the upper active layer may have peak points and valley points, and the peak points of the doping profile of the n-type impurity may be disposed away from the valley points of the In content profile.

The peak points of the doping profile of the n-type impurity may be disposed between the peak point and the valley point of the In content profile.

The peak points of the doping profile of the n-type impurity may be disposed between two peak points of the In content profile.

The doping profile of the n-type impurity may be left and right asymmetric with respect to the peak point of the doping profile of the n-type impurity.

The light emitting diode may further include a V-pit generation layer disposed between the first conductivity type semiconductor layer and the lower active layer; and a superlattice layer disposed between the V-pit generation layer and the lower active layer.

The light emitting device may further include an electron blocking layer disposed between the second conductivity type semiconductor layer and the upper active layer.

An intensity of light emitted from the lower active layer may be greater than that of light emitted from the upper active layer.

A light emitting device according to an exemplary embodiment of the present disclosure includes a first lead and a second lead; a housing covering the first lead and the second lead and defining a cavity; and a light emitting diode disposed in the cavity of the housing and electrically connected to the first and second leads, in which the light emitting diode includes: a first conductivity type semiconductor layer; a second conductivity type semiconductor layer; a lower active layer disposed between the first conductivity type semiconductor layer and the second conductivity type semiconductor layer; and an upper active layer disposed between the lower active layer and the second conductivity type semiconductor layer, in which the lower active layer emits light having a wavelength shorter than that of the upper active layer, the upper active layer includes a plurality of well layers and a plurality of barrier layers, at least one of the plurality of barrier layers includes a first barrier layer and a second barrier layer having an n-type impurity doping concentration lower than that of the first barrier layer, and the first barrier layer is closer to the first conductivity type semiconductor layer than the second barrier layer.

Each of the plurality of well layers may include In, an In content profile in the upper active layer may have peak points and valley points, a doping profile of the n-type impurity in the upper active layer may have peak points and valley points, and the peak points of the doping profile of the n-type impurity may be disposed away from the valley points of the In content profile.

The light emitting device may emit white light without a phosphor.

### [Description of Drawings]

FIG. 1 is a schematic cross-sectional view illustrating a light emitting diode according to a first embodiment of the present disclosure.
FIG. 2 is a partial cross-sectional view of an enlarged portion of FIG. 1.
FIG. 3 is a schematic band diagram illustrating the light emitting diode according to the first embodiment of the present disclosure.
FIG. 4 is a schematic cross-sectional view illustrating an active region on a longer-wavelength side of the light emitting diode according to the first embodiment of the present disclosure.
FIG. 5 shows profiles of In content and Si content in the active region on the longer-wavelength side of the light emitting diode according to the first embodiment of the present disclosure.
FIG. 6A is a schematic band diagram illustrating a light emitting diode according to a second embodiment of the present disclosure.
FIG. 6B shows profiles of In content and Si content in an active region on a longer-wavelength side of the light emitting diode according to the second embodiment of the present disclosure.
FIG. 7A is a schematic band diagram illustrating a light emitting diode according to a third embodiment of the present disclosure.
FIG. 7B shows profiles of In content and Si content in an active region on a longer-wavelength side of the light emitting diode according to the third embodiment of the present disclosure.
FIG. 8A is a schematic band diagram illustrating a light emitting diode according to a fourth embodiment of the present disclosure.
FIG. 8B shows profiles of In content and Si content in an active region on a longer-wavelength side of the light emitting diode according to the fourth embodiment of the present disclosure.
FIG. 9A is a schematic band diagram illustrating a light emitting diode according to a fifth embodiment of the present disclosure.
FIG. 9B shows profiles of In content and Si content in an active region on a longer-wavelength side of the light emitting diode according to the fifth embodiment of the present disclosure.
FIG. 10A is a schematic band diagram illustrating a light emitting diode according to a sixth embodiment of the present disclosure.
FIG. 10B shows profiles of In content and Si content in an active region on a longer-wavelength side of the light emitting diode according to the sixth embodiment of the present disclosure.
FIG. 11 is a graph for explaining a light intensity according to a wavelength of the light emitting diode fabricated according to the first embodiment of the present disclosure.
FIG. 12A is a schematic plan view illustrating a light emitting device according to an exemplary embodiment of the present disclosure.
FIG. 12B is a schematic cross-sectional view taken along line A-A' of FIG. 12A.
FIG. 12C is a schematic cross-sectional view taken along line B-B' of FIG. 12A.
FIG. 13 is a schematic cross-sectional view illustrating a light emitting device according to another exemplary embodiment.

### [Detailed Description of the Illustrated Embodiments]

Hereinafter, exemplary embodiments of the present disclosure will be described in detail with reference to the accompanying drawings. The following embodiments are provided by way of example so as to fully convey the spirit of the present disclosure to those skilled in the art to which the present disclosure pertains. Accordingly, the present disclosure is not limited to the exemplary embodiments disclosed herein and can also be implemented in different forms. In the drawings, widths, lengths, thicknesses, and the like of elements can be exaggerated for clarity and descriptive purposes. When an element or layer is referred to as being "disposed above" or "disposed on" another element or layer, it can be directly "disposed above" or "disposed on" the other element or layer or intervening elements or layers can be present. Throughout the specification, like reference numerals denote like elements having the same or similar functions.

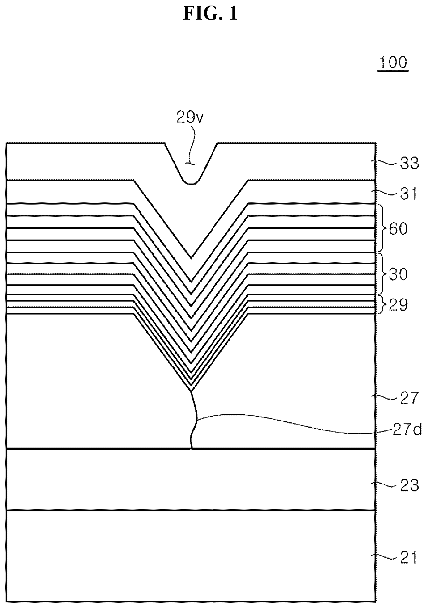

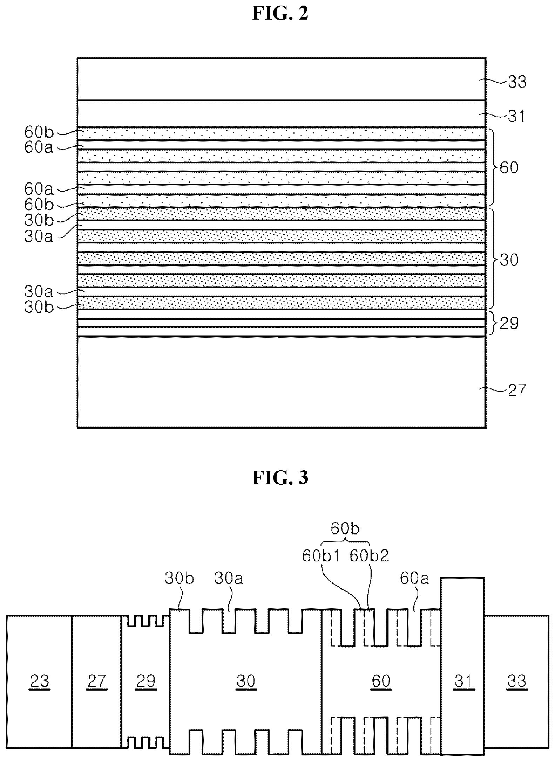

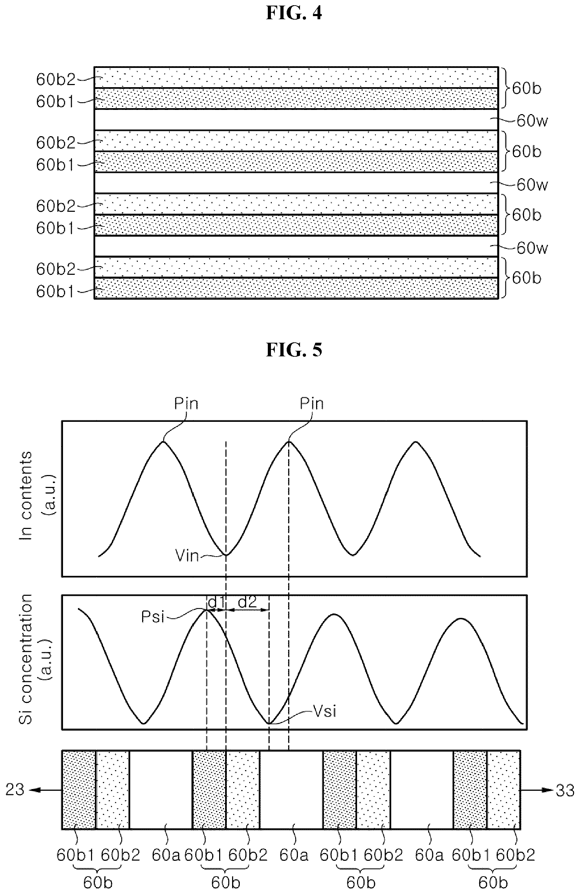

FIG. 1 is a schematic cross-sectional view illustrating a light emitting diode 100 according to a first embodiment of the present disclosure, FIG. 2 is a partial cross-sectional view of an enlarged portion of FIG. 1, FIG. 3 is a schematic band diagram illustrating the light emitting diode according to the first embodiment of the present disclosure, and FIG. 4 is a schematic cross-sectional view illustrating an active region on a longer-wavelength side of the light emitting diode according to the first embodiment of the present disclosure

Referring to FIGs. 1, 2, 3, and 4, the light emitting diode 100 according to the first embodiment of the present disclosure includes a lower active layer 30 and an upper active layer 60. Furthermore, the light emitting diode 100 may include a substrate 21, a first conductivity type semiconductor layer 23, a V-pit generation layer 27, and a second conductivity type semiconductor layer 33, and additionally, an electron blocking layer 31 may be further included.

The substrate 21 is a growth substrate for growing a gallium nitride-based semiconductor layer, and may be, for example, a sapphire substrate, a GaN substrate, a SiC substrate, a Si substrate, a spinel substrate, or the like. The substrate 21 may have protrusions, and may be, for example, a patterned sapphire substrate. However, the inventive concepts are not limited thereto, and may be a substrate having a flat upper surface, for example, a sapphire substrate.

The first conductivity type semiconductor layer 23 may include a nitride-based semiconductor layer doped with an n-type impurity, and may be formed of, for example, a GaN layer doped with Si. A Si doping concentration doped in the first conductivity type semiconductor layer 23 may be 5×10¹⁷/cm³ to 5×10¹⁹ /cm³. The first conductivity type semiconductor layer 23 may be grown by supplying a metallic source gas into a chamber using Metal Organic Chemical Vapor Deposition (MOCVD) technology under a growth pressure of 150 Torr to 200 Torr at 1000°C to 1200°C (e.g., 1050°C to 1 100°C).

The first conductivity type semiconductor layer 23 may include an n-type contact layer. In addition, to grow the first conductivity type semiconductor layer 23 on the substrate 21, a nucleation layer and a high-temperature buffer layer may be additionally formed. The nucleation layer, the high-temperature buffer layer, and the first conductivity type semiconductor layer 23 may be continuously formed on the substrate 21 in the chamber, and threading dislocations formed in the high-temperature buffer layer may be transferred to the first conductivity type semiconductor layer 23.

The first conductivity type semiconductor layer 23 may have a first refraction index n1, and a surface in which the first conductivity type semiconductor layer 23 is in contact with a patterned substrate 21 may be an interface in which a refraction index thereof changes. The substrate 21 may have a refraction index smaller than that of the first conductivity type semiconductor layer 23, and thus, when light generated in the active layers 30 and 60 is incident on the substrate 21, it may be refracted at an angle greater than an incident angle with respect to a normal of the interface. Accordingly, by employing the substrate 21 having the refraction index smaller than that of the first conductivity type semiconductor layer 23, light may be evenly distributed from an upper surface to a side surface of the substrate 21.

The first conductivity type semiconductor layer 23 may have a band gap energy higher than an energy of light generated from the light emitting diode 100. Accordingly, the first conductivity type semiconductor layer 23 has a low light absorption rate with respect to light generated from the light emitting diode 100.

As shown in FIG. 1, the V-pit generation layer 27 is disposed on the first conductivity type semiconductor layer 23. In an exemplary embodiment of the present disclosure, the V-pit generation layer 27 may be formed of, for example, a GaN layer. The V-pit generation layer 27 may be grown at a temperature relatively lower than that for growing the first conductivity type semiconductor layer 23, for example, about 900°C, and thus, V-pits 27v are formed in the V-pit generation layer 27.

By growing the V-pit generation layer 27 at the temperature relatively lower than that for growing the first conductivity type semiconductor layer 23, the V-pit 27v may be formed by artificially lowering a crystal quality of the nitride semiconductor layer to be grown and promoting a three-dimensional growth.

The V-pits 27v may have a hexagonal pyramid shape when a growth plane of the nitride semiconductor layer is a c-plane. The V-pits 27v may be formed at upper ends of threading dislocations 27d.

The V-pit generation layer 27 may be formed to have a thickness smaller than that of the first conductivity type semiconductor layer 23, and for example, to have a thickness of about 450 nm to 600 nm. Sizes of the V-pits 27v formed in the V-pit generation layer 27 may be adjusted through a growth condition and a growth time of the V-pit generation layer 27. In an exemplary embodiment, a maximum width of an inlet of the V-pit 27v formed in the V-pit generation layer 27 may generally exceed about 200 nm. Alternatively, the maximum width of the inlet of the V-pit 27v may be greater than a thickness of at least one of the lower active layer 30 and the upper active layer 60. Furthermore, the maximum width of the inlet of the V-pit 27v may be smaller than the thickness of the first conductivity type semiconductor layer 23. Accordingly, light mixing of a plurality of wavelengths contributing to a white wavelength may be effectively carried out even in the first conductivity type semiconductor layer 23, as well as in the active layer.

In the illustrated exemplary embodiment, although it is described that the V-pit generation layer 27 is a single layer, the inventive concepts are not limited thereto, and may be multiple layers. For example, the V-pit generation layer 27 may include at least two of GaN, AlGaN, InGaN, or AlGaInN layers.

The thickness of the V-pit generation layer 27 particularly affects the size of the V-pit 27v. Moreover, the size of the V-pit 27v is considered to play a major role in generating light having a spectrum of multi-bands.

The V-pit generation layer 27 may have a higher band gap energy than an energy of light generated in the light emitting diode 100, and thus, it has a low light absorption rate with respect to light generated in the light emitting diode 100. Furthermore, the light absorption rate of the V-pit generation layer 27 may be higher than that of the electron blocking layer 31 with respect to light generated from the light emitting diode 100. In particular, when a plurality of peak wavelengths is formed in the light emitting diode 100, the light absorption rate of the V-pit generation layer 27 may be higher than that of the electron blocking layer 31 for a spectrum of light having a relatively shorter peak wavelength. Accordingly, since light of a wavelength having a low contribution to white light formation may be absorbed by the semiconductor layer, an amount of light of a wavelength having a high contribution to white light formation is relatively increased, thereby enabling the light emitting diode 100 to implement white light. In addition, the V-pit generation layer 27 may have a refraction index n2 smaller than those of well layers 30a and 60a of the active layers 30 and 60. Alternatively, the V-pit generation layer 27 may have the refraction index n2 greater than those of barrier layers 30b and 60b of the active layers 30 and 60. Since the refraction index of the V-pit generation layer 27 has a value between the refractive indices of the well layers 30a and 60a and refractive indices of the barrier layers 30b and 60b, it serves to relieve a rapid change in refraction index of the well layers and the barrier layers, thereby helping to extract light.

A superlattice layer 29 may be disposed on the V-pit generation layer 27. The superlattice layer 29 may be grown along the V-pits 27v of the V-pit generation layer 27. The superlattice layer 29 may be formed of, for example, a plurality of pairs of InGaN/GaN. The superlattice layer 29 may be employed to improve crystalline quality of the lower active layer 30 and the upper active layer 60 formed on the V-pit generation layer 27.

The lower active layer 30 and the upper active layer 60 may be disposed on the superlattice layer 29. The lower active layer 30 and the upper active layer 60 may have a multi-quantum well structure, and may emit light by recombination of electrons and holes.

The lower active layer 30 and the upper active layer 60 may be disposed on the V-pit generation layer 27, and may be grown along the shape of the V-pit 27v formed in the V-pit generation layer 27. The lower active layer 30 and the upper active layer 60 may be configured, for example, as at least one of groups II-VI and groups III-V compound semiconductor.

As shown in FIG. 2, the lower active layer 30 includes a plurality of well layers 30a and a plurality of barrier layers 30b, in which the well layers 30a and the barrier layers 30b are alternately disposed. The well layer 30a and the barrier layer 30b may be formed of, for example, a semiconductor material having a composition formula of InₓAl_{y}Ga_{1-x-y}N (0≤x≤1, 0≤y≤1, 0≤x+y<1). For example, they may include at least one of pairs of InGaN/GaN, GaN/AlGaN, AlGaN/AlGaN, InGaN/AlGaN, InGaN/InGaN, AlGaAs/GaAs, InGaAs/GaAs, InGaP/GaP, AlInGaP/InGaP, or InP/GaAs.

Like the lower active layer 30, the upper active layer 60 may also have a structure in which a plurality of well layers 60a and a plurality of barrier layers 60b are alternately disposed. The lower active layer 30 emits light having a wavelength shorter than the upper active layer 60, and thus, the well layer of the lower active layer 30 may have a band gap wider than that of the well layer 60a of the upper active layer 60. For example, an amount of In in the well layer of the lower active layer 30 is less than that of In in the well layer 60a of the upper active layer 60.

The lower active layer 30 and the upper active layer 60 may be grown along a shape of an upper surface of the V-pit generation layer 27, and may include a region grown along a flat surface of the V-pit generation layer 27 and a region formed along an inclined surface of the V-pit. FIG. 2 is an enlarged view of the region in which the lower active layer 30 and the upper active layer 60 are grown along the flat surface of the V-pit generation layer 27.

When a crystal plane of the flat surface of the V-pit generation layer 27 is a (0001) plane, the lower active layer 30 and the upper active layer 60 may be grown in a [0001] direction perpendicular to the flat surface. Meanwhile, the inclined surface of the V-pit 27v has a (10-11) or {10-11} crystal plane, and the lower and upper active layers 30 and 60 may be grown in a [10-11] or < 10-11> direction. The crystal plane {10-11} and a vector <10-11> of the inclined surface of the V-pit represent six inclined surfaces and six inclined axes of the V-pit in a form of a hexagonal pyramid.

In the lower active layer 30, the well layers 30a formed outside the V-pits 27v may have a third refraction index n3, and the well layers 30a formed along the inclined surfaces of the V-pits 27v may have a fourth refraction index n4, in which the third refraction index n3 may be greater than the fourth refraction index n4. The light emitting diode 100 may include regions having different refractive indices from one another in the lower active layer 30. Assuming that a direction from the lower active layer 30 toward the substrate 21 is referred to as a first direction and a direction perpendicular to the first direction is referred to as a second direction, since the lower active layer 30 includes the regions having different refraction indices from one another along the second direction, light extraction may be more effective, and an implementation of white light or colored light may be effective. In addition, side emission of light may be increased through refraction of light by the refraction index, which may reduce an effect of light generated from each of the lower active layer 30 and the upper active layer 60 directly on each other.

In another exemplary embodiment, a plurality of regions having the fourth refraction index n4 may be disposed, and a region having the third refraction index n3 may be disposed between the regions having the fourth refraction index n4.

In the upper active layer 60, the well layers 60a formed outside the V-pits 27v may have a fifth refraction index n5, and the well layers 60a formed along the inclined surfaces of the V-pits 27v may have a sixth refraction index n6, in which the fifth refraction index n5 may be greater than the sixth refraction index n6. The upper active layer 60 may include regions having different refractive indices within one layer. Assuming that a direction from the upper active layer 60 toward the substrate 21 is referred to as a first direction and a direction perpendicular to the first direction is referred to as a second direction, since the upper active layer 60 includes the regions having different refraction indices from one another along the second direction, light extraction may be more effective, and an implementation of white light or colored light may be effective.

In another exemplary embodiment, the upper active layer 60 may include a plurality of regions having the sixth refraction index n6, and regions having the fifth reflection index n5 may be disposed between the regions having the sixth refraction index n6.

The fifth refraction index n5 may have a refraction index higher than the third refraction index n3, and the sixth refraction index n6 may have a refraction index higher than the fourth refraction index n4. The first refraction index, the second refraction index, the third refraction index, and the fifth refraction index may have a relationship of n1≤n2<n3<n5.

Although two active layers 30 and 60 have been illustrated and described as being disposed in the illustrated exemplary embodiment, a larger number of active layers may be disposed.

Composition ratios of group III elements of the well layers in the active layers 30 and 60, that is, In, Al, and Ga, may be selected according to a desired light. The upper active layer 60 and the lower active layer 30 may emit light having different peak wavelengths from each other. In an exemplary embodiment, a band of light emitted from the upper active layer 60 and a band of light emitted from the lower active layer 30 may be spaced apart from each other. In another exemplary embodiment, the band of light emitted from the upper active layer 60 and the band of light emitted from the lower active layer 30 may partially overlap. In addition, a partially overlapped region may be disposed between a plurality of peaks, and may have at least a partial amount of light.

In an exemplary embodiment, the lower active layer 30 may emit light having a wavelength shorter than a wavelength of light emitted from the upper active layer 60. The peak wavelength of light emitted from the lower active layer 30 may be within a range of about 350nm to 500nm. For example, the lower active layer 30 may include an InGaN well layer and a GaN barrier layer, and thicknesses of the well layer and the barrier layer may be, for example, about 3.0nm and about 5.8nm, respectively, and an indium concentration in the well layer may be about 10% to 20% to emit shorter-wavelength light.

The upper active layer 60 may emit light having a peak wavelength longer than the peak wavelength of light emitted from the lower active layer 30. The peak wavelength of light emitted from the upper active layer 60 may be in a range of about 500nm to 600nm. For example, the upper active layer 60 may include an InGaN well layer 60a and a GaN barrier layer 60b, thicknesses of the well layer and the barrier layer may be larger than those of the well layer 30a and the barrier layer 30b of the lower active layer 30, and may be, for example, about 3.5nm and about 10nm, respectively. An indium concentration in the well layer 60a of the upper active layer 60 is higher than the indium concentration in the well layer 30a of the lower active layer 30, and may be, for example, about 20% to 40%. However, the inventive concepts are not limited thereto, and materials and thicknesses of each of the active layers 30 and 60 are not limited to those presented above. For example, the barrier layers 30b and 60b may include Al, and may be formed of, for example, AlGaN or InAlGaN. The well layers 30a and 60a may also include Al, and may be formed of, for example, InAlGaN.

A last barrier layer among the barrier layers 30b of the lower active layer 30 may contact a first barrier layer among the barrier layers 60b of the upper active layer 60. A last barrier layer 30b of the lower active layer 30 may serve as the first barrier layer of the upper active layer 60.

The second conductivity type semiconductor layer 33 is disposed on the upper active layer 60. As shown in FIGs. 1 and 2, the electron blocking layer 31 may be disposed between the second conductivity type semiconductor layer 33 and the upper active layer 60. The electron blocking layer 31 may include, for example, a p-type AlxGa1-xN layer.

The second conductivity type semiconductor layer 33 may be formed of a semiconductor layer doped with a p-type impurity, for example, GaN. The second conductivity type semiconductor layer 33 may be formed as a single layer or multiple layers, and may include a p-type contact layer. The second conductivity type semiconductor layer 33 may have a seventh refraction index n7. The second conductivity type semiconductor layer 33 may have a band gap higher than the energy of light generated from the light emitting diode 100, and thus may have a relatively low light absorption rate. As shown in FIG. 1, the second conductivity type semiconductor layer 33 may have a concave groove over the V-pit 27v. In the illustrated exemplary embodiment, since the second conductivity type semiconductor layer 33 does not completely fill the V-pit 27v, light loss that may occur while light generated in the second well region 30-2 in the V-pit 27v passes through the second conductivity type semiconductor layer 33 may be reduced. The inventive concepts are not necessarily limited thereto, and the second conductivity type semiconductor layer 33 may be formed to fill the V-pit 27v to improve light extraction by generating light refraction due to a smooth surface.

In addition, since the second conductivity type semiconductor layer 33 having the refraction index different from those of the active layers 30 and 60 is disposed within the V-pit 27v, scattering and total internal reflection of light generated in the active layers 30 and 60 may be increased, thereby increasing light extraction efficiency of the light emitting diode.

Meanwhile, the upper active layer 60 is disposed closer to the second conductivity type semiconductor layer 33 than the lower active layer 30. In general, holes have a relatively slow mobility compared to electrons. Holes injected from the second conductivity type semiconductor layer 33 are mainly combined with electrons in the upper active layer 60, and thus, the number of holes injected into the lower active layer 30 is relatively small, so that an intensity of light emitted from the lower active layer 30 is weaker than that of light emitted from the upper active layer 60. This phenomenon is particularly serious when the light emitting diode is operated under a low current density, for example, a current density of 35mA/cm² or less. The present disclosure provides a structure for solving this drawback, which will be described in detail later with reference to FIGs. 3, 4, and 5.

Referring to FIGs. 3 and 4, each barrier layer 60b of the upper active layer 60 includes a first barrier layer 60b1 and a second barrier layer 60b2. The second barrier layer 60b2 is disposed closer to the second conductivity type semiconductor layer 33 than the first barrier layer 60b1. The first barrier layer 60b1 and the second barrier layer 60b2 have a difference in doping concentrations of n-type impurities. The first barrier layer 60b1 is grown by being doped with n-type impurities at a concentration higher than that of the second barrier layer 60b2, and the second barrier layer 60b2 has a doping concentration lower than that of the first barrier layer 60b 1 or grown without intentional doping. That is, a doping profile of the n-type impurities doped in the barrier layer 60b of the upper active layer 60 may be asymmetrical with respect to a center of the barrier layer 60b.

Referring to FIG. 5, a profile of In contents and a doping profile of n-type impurities, such as Si, can be seen. Looking at the In content profile, a peak Pin is formed at a center of each well layer 60a, and a valley Vin is formed at the center of the barrier layer 60b. Meanwhile, looking at the doping profile of Si, a peak Psi is formed in a region skewed toward the first conductivity type semiconductor layer 23 from the center of the barrier layer 60b, and a valley Vsi is formed in a region skewed toward the first conductivity type semiconductor layer 23 from the well layer 60a. Accordingly, the peak Pin of the In content profile and the valley Vsi of the Si doping profile are formed in different regions and do not coincide with each other. In addition, the valley Vin of the In content profile and the peak Psi of the Si doping profile are formed in different regions and do not coincide with each other. The peak Psi of Si is disposed in a region between the two peaks Pin of the In content profile, and disposed closer to the peak Pin close to the first conductivity type semiconductor layer 23.

Alternatively, the peak Psi of the Si doping profile may be disposed between at least one valley Vin of the In content profile and the peak Pin of the In content profile disposed on one side of the at least one valley Vin, and the valley Vsi of the Si doping profile may be disposed between the at least one valley Vin of the In content profile and the peak Pin of the In content profile disposed on another side of the at least one valley Vin. In this case, a lateral distance d1 from a valley Vin point of the In content profile to the peak Psi of the Si doping profile may be different from a lateral distance d2 from the valley Vin point of the In content profile to the valley Vsi of the Si doping profile. Preferably, the d1 may be shorter than the d2.

The doping profile of Si may be left and right asymmetric with respect to the peak Psi. In addition, heights of the peaks Psi in the Si doping profile may be different from one another, and for example, the height of the peak Psi may be higher as it is closer to the first conductivity type semiconductor layer 23. Alternatively, the Si doping profile may have different left and right inclination angles with respect to the peak Psi. Accordingly, it is possible to control a speed of electron movement.

In the doping profile of Si, a plurality of peaks Psi may be formed, and a difference in Si doping concentration between the plurality of peaks Psi may be within 50% of a doping concentration of a highest peak Psi.

According to an exemplary embodiment of the present disclosure, the barrier layers 60b formed between the well layers 60a of the upper active layer 60 have a relatively low doping concentration compared to that of the barrier layers 30b of the lower active layer 30. Furthermore, each of the barrier layers 60b of the upper active layer 60 includes the second barrier layer 60b2 having a doping concentration lower than that of the first barrier layer 60b 1, and the second barrier layer 60b2 is disposed closer to the second conductivity type semiconductor layer 33 than the first barrier layer 60b1. Accordingly, when holes are injected from the second conductivity type semiconductor layer 33, holes injected into the upper active layer 60 first encounter the second barrier layer 60b2 close to the second conductivity type semiconductor layer 33. In this case, by making the doping concentration of the second barrier layer 60b2 relatively low, coupling between electrons and holes may be intentionally reduced, and a mobility of holes may be improved. In addition, since the mobility of holes is improved, an injection efficiency of holes delivered to the lower active layer 30 increases, and an effective number of holes that can be combined with electrons in the lower active layer 30 increases.

Moreover, the first barrier layer 60b1 formed on the barrier layer 60b of the upper active layer 60 is adjacent to the second barrier layer 60b2 having a relatively low doping concentration within a same barrier layer 60b, and may have a doping concentration lower than that of the first barrier layer 60b1. Accordingly, an electron-rich region and an electron-poor region are formed together in a single barrier layer 60b, where the electron-rich region is disposed close to the first conductivity type semiconductor layer 23, the electron-poor region is disposed close to the second conductivity type semiconductor layer 33, and holes reach the electron-rich region first. However, since a conductivity of the electron-rich region is greater than that of the electron-poor region, holes are more likely to enter the well layer 60a through the electron-rich region with higher conductivity, thereby increasing a radiation efficiency of the upper active layer 60. In addition, since a hole -tunneling is possible in the electron-rich region, a hole injection efficiency into the lower active layer 30 may be increased, and thus, a white light emitting device having a desired CIE (x, y) range may be implemented.

Furthermore, since a thickness of a highly doped first barrier layer 60b1 in the barrier layer 60b of the upper active layer 60 becomes relatively small, a possibility of the hole-tunneling without being trapped in the barrier layer 60b increases. Accordingly, holes may more easily pass through the upper active layer 60, and thus, a radiation efficiency of the lower active layer 30 may be increased, and the white light emitting device having the desired CIE (x, y) range may be implemented. In addition, cool white light may be easily implemented by increasing a radiation intensity of the lower active layer 30 emitting shorter-wavelength light.

In the illustrated exemplary embodiment, the doping concentration of each second barrier layer 60b2 in the barrier layers 60b may be similar or identical to each other, and thus, the mobility of holes of the upper active layer 60 may be uniform in an entire region, and it is possible to reduce strain change occurring in the upper active layer 60. However, the inventive concepts are not limited thereto.

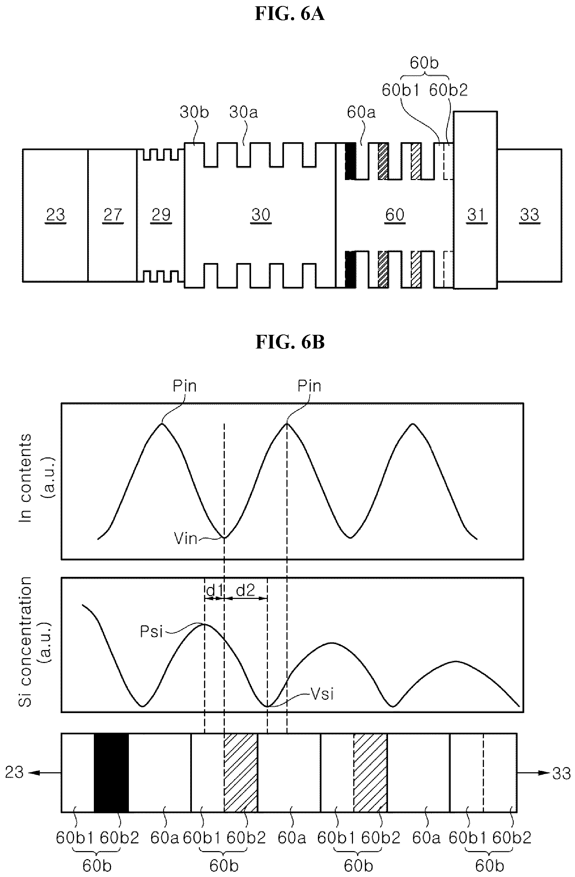

FIG. 6A is a schematic band diagram illustrating a light emitting diode according to a second embodiment of the present disclosure, and FIG. 6B shows profiles of In content and Si content in an active region on a longer-wavelength side of the light emitting diode according to the second embodiment of the present disclosure.

Referring to FIG. 6A, the light emitting diode according to the illustrated exemplary embodiment is generally similar to the light emitting diode 100 described with reference to FIGs. 1 through 5, but doping concentrations of the second barrier layers 60b2 are different from each other.

A doping concentration doped in the second barrier layers 60b2 is lower than a doping concentration doped in the first barrier layers 60b 1, and furthermore, the doping concentrations in the second barrier layers 60b2 may decrease from the first conductivity type semiconductor layer 23 toward the second conductivity type semiconductor layer 33. A doping concentration of a second barrier layer 60b2 closest to the first conductivity type semiconductor layer 23 is the highest among those of the second barrier layers 60b2, and a doping concentration of a second barrier layer 60b2 closest to the second conductivity type semiconductor layer 33 is the lowest among those of the second barrier layers 60b2. The doping concentration may sequentially decrease from the second barrier layer 60b2 closest to the first conductivity type semiconductor layer 23 to the second barrier layer 60b2 closest to the second conductivity type semiconductor layer 33. That is, a height of a peak Psi of a Si doping profile may sequentially change differently.

Referring to FIG. 6B, a profile of an In content and a doping profile of n-type impurities, such as Si, can be seen. Looking at the In content profile, a peak Pin is formed at a center of each well layer 60a, and a valley Vin is formed at a center of the barrier layer 60b. Meanwhile, looking at the doping profile of Si, the peak Psi is formed in a region skewed toward the first conductivity type semiconductor layer 23 from the center of the barrier layer 60b, and a valley Vsi is formed in a region skewed toward the first conductivity type semiconductor layer 23 from the well layer 60a. Accordingly, the peak Pin of the In content profile and the valley Vsi of the Si doping profile are formed in different regions and do not coincide with each other. In addition, the valley Vin of the In content profile and the peak Psi of the Si doping profile are formed in different regions and do not coincide with each other. The peak Psi of Si is disposed in a region between the two peaks Pin of the In content profile, and disposed closer to the peak Pin close to the first conductivity type semiconductor layer 23.

Alternatively, the peak Psi of the Si doping profile may be disposed between at least one valley Vin of the In content profile and the peak Pin of the In content profile disposed on one side of the at least one valley Vin, and the valley Vsi of the Si doping profile may be disposed between the at least one valley Vin of the In content profile and the peak Pin of the In content profile disposed on another side of the at least one valley Vin. In this case, a lateral distance d1 from a valley Vin point of the In content profile to the peak Psi of the Si doping profile may be different from a lateral distance d2 from the valley Vin point of the In content profile to the valley Vsi of the Si doping profile. Preferably, the d1 may be shorter than the d2.

The doping profile of Si may be left and right asymmetric with respect to the peak Psi. In addition, heights of the peaks Psi in the Si doping profile may be different from one another, and for example, the height of the peak Psi may be higher as it is closer to the first conductivity type semiconductor layer 23. Alternatively, the Si doping profile may have different left and right inclination angles with respect to the peak Psi. Accordingly, it is possible to control a speed of electron movement. A first full width at half maximum (FWHM) included in any first peak Psi and a second full width at half maximum (FWHM) included in a second peak Psi disposed adjacent to the first peak Psi may have different values from each other. Preferably, among a plurality of peaks Psi, a full width at half maximum (FWHM) of a peak Psi disposed at a relatively higher position may be formed smaller. In addition, the peak Psi having the smaller full width at half maximum (FWHM) may be disposed close to the first conductivity type semiconductor layer 23. Accordingly, an excitation rate of a shorter-wavelength active layer may be increased even at a low current density.

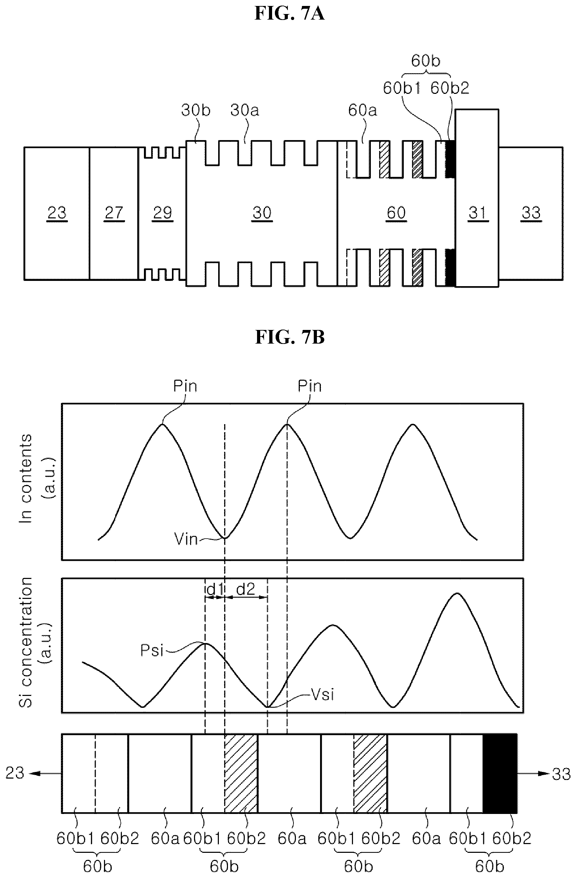

FIG. 7A is a schematic band diagram illustrating a light emitting diode according to a third embodiment of the present disclosure, and FIG. 7B shows profiles of In content and Si content in an active region on a longer-wavelength side of the light emitting diode according to the third embodiment of the present disclosure.

Referring to FIG. 7A, the light emitting diode according to the illustrated exemplary embodiment is generally similar to the light emitting diode 100 described with reference to FIGs. 1 through 6B, but doping concentrations doped in the second barrier layers 60b2 are different from each other.

A doping concentration doped in the second barrier layers 60b2 is lower than a doping concentration doped in the first barrier layers 60b 1, and furthermore, the doping concentrations in the second barrier layers 60b2 may decrease from the first conductivity type semiconductor layer 23 toward the second conductivity type semiconductor layer 33. A doping concentration of a second barrier layer 60b2 closest to the first conductivity type semiconductor layer 23 is the highest among those of the second barrier layers 60b2, and a doping concentration of a second barrier layer 60b2 closest to the second conductivity type semiconductor layer 33 is the lowest among those of the second barrier layers 60b2. The doping concentration may sequentially decrease from the second barrier layer 60b2 closest to the first conductivity type semiconductor layer 23 to the second barrier layer 60b2 closest to the second conductivity type semiconductor layer 33.

Referring to FIG. 7B, a profile of an In content and a doping profile of n-type impurities, such as Si, can be seen. Looking at the In content profile, a peak Pin is formed at a center of each well layer 60a, and a valley Vin is formed at a center of the barrier layer 60b. Meanwhile, looking at the doping profile of Si, the peak Psi is formed in a region skewed toward the first conductivity type semiconductor layer 23 from the center of the barrier layer 60b, and a valley Vsi is formed in a region skewed toward the first conductivity type semiconductor layer 23 from the well layer 60a. Accordingly, the peak Pin of the In content profile and the valley Vsi of the Si doping profile are formed in different regions and do not coincide with each other. In addition, the valley Vin of the In content profile and the peak Psi of the Si doping profile are formed in different regions and do not coincide with each other. The peak Psi of Si is disposed in a region between the two peaks Pin of the In content profile, and disposed closer to the peak Pin close to the first conductivity type semiconductor layer 23.

Alternatively, the peak Psi of the Si doping profile may be disposed between at least one valley Vin of the In content profile and the peak Pin of the In content profile disposed on one side of the at least one valley Vin, and the valley Vsi of the Si doping profile may be disposed between the at least one valley Vin of the In content profile and the peak Pin of the In content profile disposed on another side of the at least one valley Vin. In this case, a lateral distance d1 from a valley Vin point of the In content profile to the peak Psi of the Si doping profile may be different from a lateral distance d2 from the valley Vin point of the In content profile to the valley Vsi of the Si doping profile. Preferably, the d1 may be shorter than the d2.

The doping profile of Si may be left and right asymmetric with respect to the peak Psi. In addition, heights of the peaks Psi in the Si doping profile may be different from one another, and for example, the height of the peak Psi may be higher as it is closer to the first conductivity type semiconductor layer 33. Alternatively, the Si doping profile may have different left and right inclination angles with respect to the peak Psi. Accordingly, it is possible to control a speed of electron movement. A first full width at half maximum (FWHM) included in any first peak Psi and a second full width at half maximum (FWHM) included in a second peak Psi disposed adjacent to the first peak Psi may have different values from each other. Preferably, among a plurality of peaks Psi, a full width at half maximum (FWHM) of the peak Psi disposed at a relatively higher position may be formed smaller. In addition, the peak Psi having the smaller full width at half maximum (FWHM) may be disposed close to the first conductivity type semiconductor layer 33. Accordingly, it is possible to balance a plurality of wavelengths for implementing white light by emitting light in a wide region from a shorter-wavelength active layer to a longer-wavelength active layer.

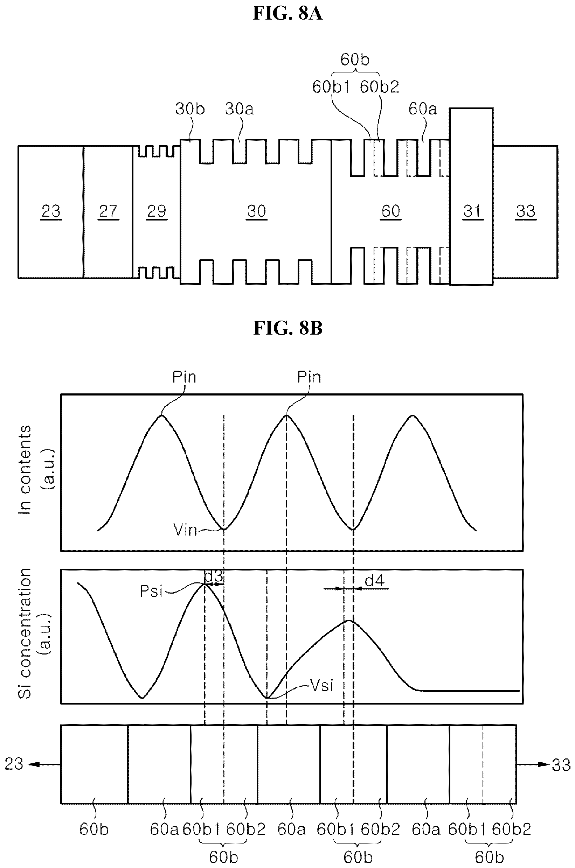

FIG. 8A is a schematic band diagram illustrating a light emitting diode according to a fourth embodiment of the present disclosure, and FIG. 8B shows profiles of In content and Si content in an active region on a longer-wavelength side of the light emitting diode according to the fourth embodiment of the present disclosure.

Referring to FIG. 8A, the light emitting diode according to the illustrated exemplary embodiment is generally similar to the light emitting diode described with reference to FIGs. 1 through 5, but the first barrier layer 60b1 and the second barrier layer 60b2 having different doping concentrations from each other are formed on the barrier layers 60b except for some of the plurality of barrier layers 60b of the upper active layer 60, instead of being formed on all of the barrier layers 60b. In particular, an electron-poor region may not be formed in a barrier layer 60b closest to the first conductivity type semiconductor layer 23, but may be formed in other barrier layers 60b except for this region. In an exemplary embodiment, the electron-poor region may be formed in more than half of the barrier layers 60b. The barrier layers 60b in which the electron-poor region is formed may be barrier layers 60b close to the second conductivity type semiconductor layer 33. In the upper active layer 60, a number of barrier layers (EBn) including the electron-poor region relative to a total number of barrier layers (Bn) may be 1: 0.49 to 1:0.99.

Referring to FIG. 8B, a profile of an In content and a doping profile of n-type impurities, such as Si, can be seen. Looking at the In content profile, a peak Pin is formed at a center of each well layer 60a, and a valley Vin is formed at a center of the barrier layer 60b. Meanwhile, looking at the doping profile of Si, the peak Psi is formed in a region skewed toward the first conductivity type semiconductor layer 23 from the center of the barrier layer 60b, and a valley Vsi is formed in a region skewed toward the first conductivity type semiconductor layer 23 from the well layer 60a. Accordingly, the peak Pin of the In content profile and the valley Vsi of the Si doping profile are formed in different regions and do not coincide with each other. In addition, the valley Vin of the In content profile and the peak Psi of the Si doping profile are formed in different regions and do not coincide with each other. The peak Psi of Si is disposed in a region between the two peaks Pin of the In content profile, and disposed closer to the peak Pin close to the first conductivity type semiconductor layer 23.

Alternatively, the peak Psi of the Si doping profile may be disposed between at least one valley Vin of the In content profile and the peak Pin of the In content profile disposed on one side of the at least one valley Vin, and the valley Vsi of the Si doping profile may be disposed between the at least one valley Vin of the In content profile and the peak Pin of the In content profile disposed on another side of the at least one valley Vin. In this case, a lateral distance d3 from a valley Vin point of the In content profile to the peak Psi of the adjacent Si doping profile may be different from a lateral distance d4 from the valley Vin point of the adjacent In content profile to the valley Vsi of the Si doping profile. Preferably, the d4 may be shorter than the d3.

The doping profile of Si may be left and right asymmetric with respect to the peak Psi. In addition, heights of the peaks Psi in the Si doping profile may be different from one another, and for example, the height of the peak Psi may be higher as it is closer to the first conductivity type semiconductor layer 23. Alternatively, the Si doping profile may have different left and right inclination angles with respect to the peak Psi. Accordingly, it is possible to control a speed of electron movement. A first full width at half maximum (FWHM) included in any first peak Psi and a second full width at half maximum (FWHM) included in a second peak Psi disposed adjacent to the first peak Psi may have different values from each other. Preferably, among a plurality of peaks Psi, a full width at half maximum (FWHM) of the peak Psi disposed at a relatively higher position may be formed smaller. In addition, the peak Psi having the smaller full width at half maximum (FWHM) may be disposed close to the first conductivity type semiconductor layer 23. Accordingly, it is possible to prevent a decrease in turn-on voltage by preventing an overflow of electrons.

According to the illustrated exemplary embodiment, a mobility of holes may be reduced just before holes enter the lower active layer 30, and as a result, an effective time during which holes have entered the lower active layer 30 can stay in the lower active layer 30 may be increased. Accordingly, a probability of combining electrons and holes in the lower active layer 30 increases, and thus, a radiation intensity of shorter-wavelength light emitted from the lower active layer 30 may be adjusted, and a white light emitting device having a desired range of CIE (x, y) may be provided.

In the illustrated exemplary embodiment, the doping concentrations of the second barrier layers 60b2 in the electron-poor region may be similar or identical to one another, but the inventive concepts are not limited thereto. As described with reference to FIG. 6 or FIG. 7, the doping concentrations doped in the second barrier layers 60b2 may be higher as they are closer to the first conductivity type semiconductor layer 23, or may be higher as they are closer to the second conductivity type semiconductor layer 33. For example, the doping concentrations doped in the second barrier layers 60b2 may be increased or decreased at a constant rate as a percentage with respect to the doping concentration doped in the first barrier layers 60b1. For example, from a second barrier layer 60b2 close to the first conductivity type semiconductor layer 23 toward a second barrier layer 60b2 close to the second conductivity type semiconductor layer 33, the doping concentrations may be increased or decreased in a certain rate, for example, 0%, 30%, 60%.

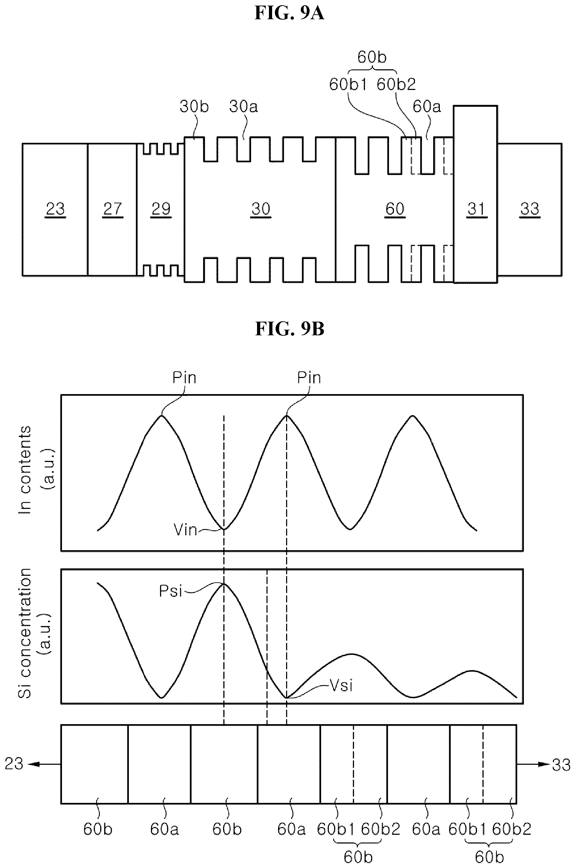

FIG. 9A is a schematic band diagram illustrating a light emitting diode according to a fifth embodiment of the present disclosure, and FIG. 9B shows profiles of In content and Si content in an active region on a longer-wavelength side of the light emitting diode according to the fifth embodiment of the present disclosure.

Referring to FIG. 9A, the light emitting diode according to the illustrated exemplary embodiment is generally similar to the light emitting diode described with reference to FIGs. 1 through 5, but the first barrier layer 60b1 and the second barrier layer 60b2 having different doping concentrations from each other are formed on the barrier layers 60b except for some of the plurality of barrier layers 60b of the upper active layer 60, instead of being formed on all of the barrier layers 60b. In particular, an electron-poor region may not be formed in a barrier layer 60b closest to the first conductivity type semiconductor layer 23, but may be formed in other barrier layers 60b except for this region. In an exemplary embodiment, the electron-poor region may be formed in half of the barrier layers 60b among the barrier layers 60b. The barrier layers 60b in which the electron-poor region is formed may be barrier layers 60b close to the second conductivity type semiconductor layer 33. In the upper active layer 60, a number of barrier layers (EBn) including the electron-poor region relative to a total number of barrier layers (Bn) may be 1: 0.5.

Although a composition profile of FIG. 9B is substantially similar to that of FIG. 8B, a content difference of at least two Si peaks Psi disposed close to the first conductivity type semiconductor layer 23 may be within 10%. In addition, a barrier layer disposed adjacent to the electron blocking layer may be undoped, and a Si peak Psi of the barrier layer adjacent to the undoped barrier layer may be half or less with respect to a highest Si peak Psi content among the barrier layers 60b.

According to the illustrated exemplary embodiment, a mobility of holes may be reduced just before holes enter the lower active layer 30, and as a result, an effective time during which holes have entered the lower active layer 30 can stay in the lower active layer 30 may be increased. Accordingly, a probability of combining electrons and holes in the lower active layer 30 increases, and thus, a radiation intensity of shorter-wavelength light emitted from the lower active layer 30 may be adjusted, and a white light emitting device having a desired range of CIE (x, y) may be provided.

In the illustrated exemplary embodiment, the doping concentrations of the second barrier layers 60b2 in the electron-poor region may be similar or identical to one another, but the inventive concepts are not limited thereto. As described with reference to FIG. 6 or FIG. 7, the doping concentrations doped in the second barrier layers 60b2 may be higher as they are closer to the first conductivity type semiconductor layer 23, or may be higher as they are closer to the second conductivity type semiconductor layer 33. For example, the doping concentrations doped in the second barrier layers 60b2 may be increased or decreased at a constant rate as a percentage with respect to the doping concentration doped in the first barrier layers 60b1.

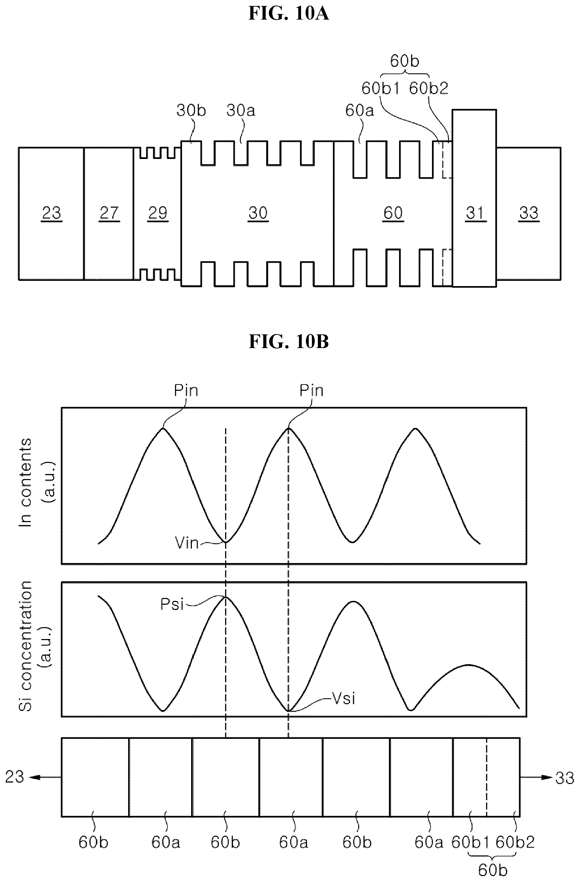

FIG. 10A is a schematic band diagram illustrating a light emitting diode according to a sixth embodiment of the present disclosure, and FIG. 10B shows profiles of In content and Si content in an active region on a longer-wavelength side of the light emitting diode according to the sixth embodiment of the present disclosure.

Referring to FIG. 10A, the light emitting diode according to the illustrated exemplary embodiment is generally similar to the light emitting diode described with reference to FIGs. 1 through 5, but the first barrier layer 60b1 and the second barrier layer 60b2 having different doping concentrations from each other are formed on portions of the barrier layers 60b among the plurality of barrier layers 60b of the upper active layer 60, instead of being formed on all of the barrier layers 60b. In particular, an electron-poor region may not be formed in a barrier layer 60b closest to the first conductivity type semiconductor layer 23, but may be formed in a barrier layer 60b closest to the second conductivity type semiconductor layer 33. In an exemplary embodiment, the electron-poor region may be formed less than half of the barrier layers 60b of the barrier layers 60b. The barrier layers 60b in which the electron-poor region is formed may be barrier layers 60b close to the second conductivity type semiconductor layer 33. In the upper active layer 60, a number of barrier layers (EBn) including the electron-poor region relative to a total number of barrier layers (Bn) may be 1: 0.01 to 1 :0.49.

Referring to FIG. 10B, in more than half of the number of barrier layers 60b, a difference in doping concentration of each Si peak Psi is within 10%, and at least one barrier layer may have a difference in Si concentration of more than 50%. In addition, a full width at half maximum (FWHM) of a Si concentration Psi of the at least one barrier layer may be greater than full widths at half maximum (FWHM) of Si concentrations Psi of the other barrier layers. Preferably, a full width at half maximum (FWHM) of a Si concentration (Psi) of a barrier layer disposed closest to the second conductivity type semiconductor layer 33 may be the largest. In addition, an inclination angle of the Si concentration Psi profile of the barrier layer disposed closest to the second conductivity type semiconductor layer 33 may be formed more gently than those of other barrier layers.

According to the illustrated exemplary embodiment, a mobility of holes may be reduced just before holes enter the upper active layer 60, and as a result, an effective time during which holes have entered the upper active layer 60 can stay in the upper active layer 60 may be increased. Accordingly, a probability of combining electrons and holes in the upper active layer 60 increases, and thus, a radiation intensity of longer-wavelength light emitted from the upper active layer 60 may be adjusted, and a white light emitting device having a desired range of CIE (x, y) may be provided. In addition, an effective time of holes existing in the lower and upper active layers 30 and 60 may be increased by reducing the mobility of holes existing in entire regions of the lower and upper active layers 30 and 60. Accordingly, it is possible to implement a white light emitting device having a range of white CIE (x, y) by adjusting intensities of shorter-wavelength and longer-wavelength light.

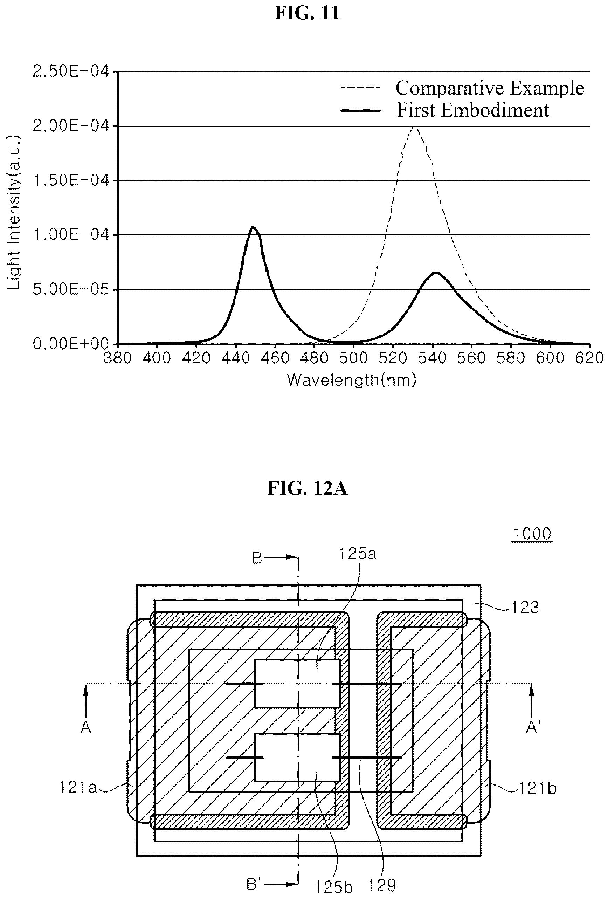

FIG. 11 is a graph for explaining a light intensity according to a wavelength of the light emitting diode fabricated according to the first embodiment of the present disclosure. In the light emitting diode of the first embodiment, the barrier layers 60b of the upper active layer 60 were all formed to have the first barrier layer 60b1 and the second barrier layer 60b2, and in a light emitting diode of a comparative example, barrier layers 60b were formed to have barrier layers 60b doped at a uniform concentration without the second barrier layer 60b2. That is, all of the barrier layers 60b of the comparative example have only electron-rich regions, and all of the barrier layers 60b of the first embodiment have electron-rich regions and electron-poor regions. Electroluminescence spectrums were measured at a same current density of 35 A/cm².

Referring to FIG. 11, in the light emitting diode of the comparative example, an intensity of a longer wavelength peak of 500nm or more emitted from an upper active layer 60 was dominant, and a peak of shorter-wavelength light of 500nm or less emitted from a lower active layer 30 hardly occurred. Since most of holes are combined with electrons in the upper active layer 60, they do not reach the lower active layer 30, and thus, it is judged that a peak intensity of the upper active layer 60 appears high, but a peak intensity of the lower active layer 30 does not appear. As a result, the light emitting diode of the comparative example does not emit white light, but emits yellow light. Furthermore, in a light emitting diode structure of the comparative example, it is more difficult for holes to reach the lower active layer 30 under a low current density of 35 A/cm² or less, and it is judged that it is difficult to implement white light.

On the contrary, in the light emitting diode of the first embodiment, an intensity of light emitted from the upper active layer 60 was relatively reduced compared to that of the comparative example, and an intensity of light emitted from the lower active layer 30 was significantly increased. By forming the electron-rich region and the electron-poor region together in the upper active layer 60, a significant portion of holes injected into the upper active layer 60 may be injected into the lower active layer 30 without being combined with electrons in the upper active layer 60, and thus, light is generated in the lower active layer 30. Accordingly, peaks of considerable intensity were generated not only in the upper active layer 60 but also in the lower active layer 30. A peak intensity of longer-wavelength light and a peak intensity of shorter- wavelength light may be adjusted by changing a structure of the barrier layer 60b of the upper active layer 60, and various white light can be implemented by adjusting the two peak intensities. In addition, since holes may be smoothly supplied to the lower active layer 30 even under a low current density, white light can be implemented even under low current density conditions. In the implementation of white light, CIE (x, y) color coordinates may be adjusted by adjusting arrangements and doping concentrations of the electron-rich region and the electron-poor region described above.

The light emitting diode according to the exemplary embodiments of the present disclosure may implement light disposed in a region surrounded by four coordinate points of color coordinates (x, y) of (0.012, 0.494), (0.2, 0.4), (0.2, 0.32), (0.04, 0.32) on a CIE 1931 color space chromaticity diagram without using a phosphor.

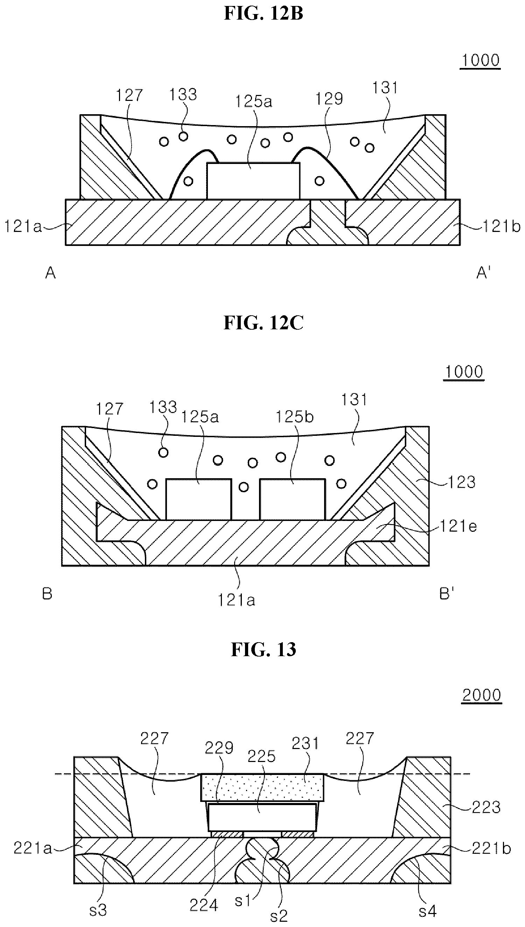

FIG. 12A is a schematic plan view illustrating a light emitting device 1000 according to an exemplary embodiment of the present disclosure, FIG. 12B is a schematic cross-sectional view taken along line A-A' of its corresponding view shown in FIG. 12A, and FIG. 12C is a schematic cross-sectional view taken along line B-B' of its corresponding view shown in FIG. 12A.

Referring to FIG. 12A through 12B, and FIG. 12C, the light emitting device 1000 may include a first lead 121a, a second lead 121b, a housing 123, light emitting diode chips 125a and 125b, and a reflector 127, bonding wires 129, and a molding member 131.

The first lead 121a and the second lead 121b may be formed of a conductive material, for example, a metal. Bottom surfaces of the first lead 121a and the second lead 121b may be partially removed by half-cutting, and thus, may include relatively thin regions. In addition, the first lead 121a and the second lead 121b may include anchors 121e protruding upward from upper surfaces of the leads 121a and 121b as shown in FIG. 12C. The anchors 121e may be formed on edges of the leads 121a and 121b, and in particular, may be disposed over half-cut regions. The anchors 121e prevent the leads 121a and 121b from being separated from the housing 123. The anchors 121e may include a region where a thickness thereof changes in cross-section view. In addition, upper surfaces and lower surfaces of the anchors 121e may not be parallel, and may be asymmetrical shapes. A portion of the anchors 121e protruding above the upper surface has an angle, and a protruding angle may be less than or equal to 60 degrees with respect to a mounting surface of the light emitting diode chip. Due to this shape, bonding with the housing 123 may be further enhanced.

The housing 123 covers side surfaces of the leads 121a and 121b and partially covers upper surfaces thereof. The housing 123 forms a cavity over the leads 121a and 121b. The housing 123 may be formed of, for example, an epoxy molding compound (EMC).

The light emitting diode chips 125a and 125b may be disposed on the first lead 121a, and may be electrically connected to the first and second leads 121a and 121b through the bonding wires 129. The light emitting diode chips 125a and 125b may include the light emitting diodes 100, 200, and 300 described in the previous embodiments. The light emitting diode chips 125a and 125b may emit light of a same color, without being limited thereto, and may emit light of different colors.

The reflector 127 may be formed on an inner wall of the housing 123. The reflector 127 may be formed of a material having a higher reflectance than that of the housing 123, and may include, for example, white silicone.

The molding member 131 covers the light emitting diode chips 125a and 125b. The molding member 131 may fill the cavity of the housing 123. The molding member 131 may be formed of transparent silicone. In an exemplary embodiment, the molding member 131 may not include a phosphor. Since the light emitting diode chips 125a and 125b emit mixed-color light, a desired mixed-color light may be implemented without using a phosphor 133. In another exemplary embodiment, the molding member 131 may include the phosphor 133. Since the light emitting diode chips 125a and 125b emit mixed-color light, an amount of the phosphor 133 used may be relatively less than that of a conventional light emitting device.

FIG. 13 is a schematic cross-sectional view illustrating a light emitting device 2000 according to another exemplary embodiment of the present disclosure.

Referring to FIG. 13, the light emitting device 2000 may include a first lead 221a, a second lead 221b, a housing 223, light emitting diode chips 225, a reflector 227, an adhesive 229, and a wavelength converter 231.

The first lead 221a and the second lead 221b may be formed of a conductive material, for example, a metal. Bottom surfaces of the first lead 221a and the second lead 221b may be partially removed by half-cutting, and thus, may include relatively thin regions. In addition, the first lead 221a and the second lead 221b may be separated from each other by etching. Furthermore, although not shown in the drawing, a through-hole may be formed in each of the first lead 221a and the second lead 221b. The through-hole may be connected to the region in which the bottom surface is partially removed. The through-holes are filled with the housing 223, thereby preventing the leads 221a and 221b from being separated from the housing 223. The through-hole is selectively applicable.

The leads 221a and 221b have surfaces facing each other. The surfaces of the leads 221a and 221b facing each other may be symmetrical. The surface of each of the leads 221a and 221b facing each other may include a first surface s1 and a second surface s2. The first surface s1 may include a region having a first radius of curvature, and the second surface s2 may include a region having a second radius of curvature. The first radius of curvature may have a value different from that of the second radius of curvature. As shown in FIG. 13, the first radius of curvature of the first surface s1 may be smaller than the second radius of curvature of the second surface s2.

Meanwhile, the first and second leads 221a and 221b may include curved surfaces, that is, a third surface s3, and a fourth surface s4, along with vertical surfaces on opposite side surfaces of each other. The opposite side surfaces may be symmetrical, but the inventive concepts are not limited thereto. The third and fourth surfaces s3 and s4 may include a region having different radii of curvature from those of the first and second surfaces s1 and s2. For example, the third surface s3 and the fourth surface s4 may include a region having the radius of curvature greater than those of the first surface s1 and the second surface s2.

Since the side surfaces of the leads 221a and 221b include the regions having different radii of curvature, a coupling force between the leads 221a and 221b and the housing 223 may be enhanced.

The housing 223 covers portions of upper surfaces of the leads 221a and 221b and portions of lower surfaces of the leads 221a and 221b. In particular, the housing 223 may fill the region in which the bottom surface is partially removed by half-cutting, and may fill the through-holes formed in the leads 221a and 221b.

The housing 223 forms a cavity over the leads 221a and 221b. The housing 223 may be formed of, for example, an epoxy molding compound (EMC).

The light emitting diode chip 225 may be flip-bonded on the first lead 221a and the second lead 221b to be electrically connected. The light emitting diode chip 225 may include the light emitting diodes 100, 200, and 300 described in the previous embodiments.

The wavelength converter 231 is disposed over the light emitting diode chip 225. The wavelength converter 231 may be adhered to the light emitting diode chip 225 through the adhesive 229. The adhesive 229 may at least partially cover an upper surface as well as a side surface of the light emitting diode chip 225. A thickness of the adhesive 229 covering the side surface of the light emitting diode chip 225 may be decreased toward a lower surface of the light emitting diode chip 225.

The wavelength converter 231 may include a phosphor. Since the light emitting diode chip 225 emits mixed-color light, an amount of phosphor used may be relatively less than that of a conventional light emitting device. By using the phosphor together with the light emitting diode chip 225 emitting mixed light, mixed light having a desired color coordinate may be easily implemented.

The reflector 227 may be formed between an inner wall of the housing 223 and the wavelength converter 231. The reflector 227 may be in contact with a side surface of the wavelength converter 231 and may be in contact with an inner wall of the molding member 223. The reflector 227 may also surround the side surfaces of the light emitting diode chip 225. The adhesive 229 may be disposed between the reflector 227 and the light emitting diode chip 225.

The reflector 227 may be formed of a material having a higher reflectance than that of the housing 223, and the reflector 227 may include regions having different heights in cross-section view. For example, it may include white silicone. The reflector 227 may include a concave upper surface. A lowest height of the concave portion may be lower than an upper surface (indicated by a dotted line) of the wavelength converter 231, and an uppermost end of the reflector 227 may be disposed higher than the upper surface of the wavelength converter 231. Accordingly, light emitted from the wavelength converter 231 in a lateral direction may be reflected on the concave upper surface of the reflector 227, and thus, light may be collected in an upper direction of the light emitting diode chip 225.

The light emitting devices 1000 and 2000 according to the illustrated exemplary embodiment may easily implement mixed-color light having the desired color coordinate by using the phosphor together with the light emitting diode chips 125a, 125b, and 225 emitting mixed-color light. In particular, cyan light located within a region surrounded by color coordinates of four points: (0.012, 0.494), (0.2, 0.4), (0.2, 0.32), (0.04, 0.32) may be implemented on the CIE 1931 color space chromaticity diagram. In addition, the light emitting devices 1000 and 2000 according to the illustrated exemplary embodiment may implement white light of the above color coordinates without using a phosphor by employing the light emitting diode described above.

While particular embodiments and aspects of the present disclosure have been illustrated and described herein, various other changes and modifications can be made without departing from the spirit and scope of the disclosure. Moreover, although various aspects have been described herein, such aspects need not be utilized in combination. Accordingly, it is therefore intended that the appended claims cover all such changes and modifications that are within the scope of the embodiments shown and described herein.

## Claims

1. A light emitting diode, comprising:
a first conductivity type semiconductor layer;
a second conductivity type semiconductor layer;
a lower active layer disposed between the first conductivity type semiconductor layer and the second conductivity type semiconductor layer; and
an upper active layer disposed between the lower active layer and the second conductivity type semiconductor layer, wherein:
the lower active layer emits light having a wavelength shorter than that of the upper active layer,
the upper active layer includes a plurality of well layers and a plurality of barrier layers,
at least one barrier layer among the plurality of barrier layers includes a first barrier layer and a second barrier layer having an n-type impurity doping concentration lower than that of the first barrier layer, and
the first barrier layer is closer to the first conductivity type semiconductor layer than the second barrier layer.

2. The light emitting diode of claim 1, wherein:
the lower active layer emits light having a first peak intensity at less than 500nm, and
the upper active layer emits light having a second peak intensity at 500nm or more.

3. The light emitting diode of claim 1,
wherein the second barrier layer is doped with a lower doping concentration than that of the first barrier layer or formed without intentional doping.

4. The light emitting diode of claim 1,
wherein all of the plurality of barrier layers include the first barrier layer and the second barrier layer.

5. The light emitting diode of claim 1, wherein:
more than half of the plurality of barrier layers, except for some barrier layers, include the first barrier layer and the second barrier layer, and
the barrier layers including the first barrier layer and the second barrier layer are disposed close to the second conductivity type semiconductor layer.

6. The light emitting diode of claim 1, wherein:
half of the plurality of barrier layers include the first barrier layer and the second barrier layer, and
the barrier layers including the first barrier layer and the second barrier layer are disposed close to the second conductivity type semiconductor layer.

7. The light emitting diode of claim 1, wherein:
less than half of the plurality of barrier layers include the first barrier layer and the second barrier layer, and
the barrier layers including the first barrier layer and the second barrier layer are disposed close to the second conductivity type semiconductor layer.

8. The light emitting diode of claim 1,
wherein at least two barrier layers among the plurality of barrier layers include the first barrier layer and the second barrier layer, and the second barrier layers of the at least two barrier layers have different doping concentrations from each other.

9. The light emitting diode of claim 8,
wherein the at least two barrier layers are arranged in an order of high or low doping concentration.

10. The light emitting diode of claim 9,
wherein the barrier layers including the first barrier layer and the second barrier layer are disposed close to the second conductivity type semiconductor layer.

11. The light emitting diode of claim 1, wherein:
each of the plurality of well layers includes In,
an In content profile in the upper active layer has peak points and valley points,
a doping profile of the n-type impurity in the upper active layer has peak points and valley points, and
the peak points of the doping profile of the n-type impurity are disposed away from the valley points of the In content profile.

12. The light emitting diode of claim 11,
wherein the peak points of the doping profile of the n-type impurity are disposed between the peak point and the valley point of the In content profile.

13. The light emitting diode of claim 11,
wherein the peak points of the doping profile of the n-type impurity are disposed between two peak points of the In content profile.

14. The light emitting diode of claim 11,
wherein the doping profile of the n-type impurity is left and right asymmetric with respect to the peak point of the doping profile of the n-type impurity.

15. The light emitting diode of claim 1, further comprising:
a V-pit generation layer disposed between the first conductivity type semiconductor layer and the lower active layer; and
a superlattice layer disposed between the V-pit generation layer and the lower active layer.

16. The light emitting diode of claim 15, further comprising:
an electron blocking layer disposed between the second conductivity type semiconductor layer and the upper active layer.

17. The light emitting diode of claim 1,
wherein an intensity of light emitted from the lower active layer is greater than that of light emitted from the upper active layer.

18. A light emitting device, comprising:
a first lead and a second lead;
a housing covering the first lead and the second lead and defining a cavity; and
a light emitting diode disposed in the cavity of the housing and electrically connected to the first and second leads,
the light emitting diode, comprising:
a first conductivity type semiconductor layer;
a second conductivity type semiconductor layer;
a lower active layer disposed between the first conductivity type semiconductor layer and the second conductivity type semiconductor layer; and
an upper active layer disposed between the lower active layer and the second conductivity type semiconductor layer, wherein:
the lower active layer emits light having a wavelength shorter than that of the upper active layer,
the upper active layer includes a plurality of well layers and a plurality of barrier layers,
at least one barrier layer among the plurality of barrier layers includes a first barrier layer and a second barrier layer having an n-type impurity doping concentration lower than that of the first barrier layer, and
the first barrier layer is closer to the first conductivity type semiconductor layer than the second barrier layer.

19. The light emitting device of claim 18, wherein:
each of the plurality of well layers includes In,
an In content profile in the upper active layer has peak points and valley points,
a doping profile of the n-type impurity in the upper active layer has peak points and valley points, and
the peak points of the doping profile of the n-type impurity are disposed away from the valley points of the In content profile.

20. The light emitting device of claim 18,
wherein the light emitting device emits white light without a phosphor.
